(19) Europäisches Patentamt
European Patent Office
Office européen des brevets

(11) Veröffentlichungsnummer: **0 271 164 B1**

(12) **EUROPÄISCHE PATENTSCHRIFT**

(45) Veröffentlichungstag der Patentschrift: **18.09.91**

(51) Int. Cl.⁵: **H05K 3/04**, H05K 3/10, H05K 3/28, H05K 3/00

(21) Anmeldenummer: **87202441.9**

(22) Anmeldetag: **07.12.87**

(54) **Werkzeug zum Herstellen eines Schaltungsmusters einer elektrischen Schaltungsplatte durch Schneiden einer Kupferplatte und Schaltungsmuster einer elektrischen Schaltungsplatte, das zur Bearbeitung mit dem Werkzeug geeignet ist.**

(30) Priorität: **09.12.86 DE 3642039**

(43) Veröffentlichungstag der Anmeldung:
**15.06.88 Patentblatt 88/24**

(45) Bekanntmachung des Hinweises auf die
Patenterteilung:
**18.09.91 Patentblatt 91/38**

(84) Benannte Vertragsstaaten:
**DE FR GB IT**

(56) Entgegenhaltungen:
**DE-A- 3 109 862**
**DE-B- 2 124 738**
**DE-B- 2 612 257**
**FR-A- 1 598 182**
**GB-A- 821 841**

(73) Patentinhaber: **Philips Patentverwaltung GmbH**
**Wendenstrasse 35 Postfach 10 51 49**
**W-2000 Hamburg 1(DE)**
(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**
(84) Benannte Vertragsstaaten:
**FR GB IT**

(72) Erfinder: **Martin, Johann**
**Markschiedsweg 27**
**W-6336 Solms/Oberbiel(DE)**

(74) Vertreter: **Kupfermann, Fritz-Joachim,**
**Dipl.-Ing. et al**
**Philips Patentverwaltung GmbH Wendenstrasse 35 Postfach 10 51 49**
**W-2000 Hamburg 1(DE)**

## Beschreibung

Die Erfindung bezieht sich auf ein Werkzeug zum Herstellen eines Schaltungsmusters einer elektrischen Schaltungsplatte mit Leitungs- und Massezügen sowie Anschlußstellen für Bauteile nach einem vorgegebenen Lay-out durch Schneiden einer Kupferplatte mit Hilfe von Werkzeugstempeln und den Stempeln zugeordneten Niederhaltern längs der Ränder der Züge und Anschlußstellen und Schaltungsmuster einer elektrischen Schaltungsplatte, das zum Bearbeiten mit Hilfe des Werkzeuges geeignet ist.

Es ist aus der DE-OS 23 05 883 eine elektrische Schaltungsplatte bekannt, bei der Leitungszüge sowie Anschlußstellen für Bauteile durch Schneiden einer Kupferplatte und Einspritzen des Schaltungsmusters in Kunststoff hergestellt werden. Die zum Schneiden geeigneten Werkzeuge sind dabei nicht beschrieben.

Es ist Aufgabe der Erfindung, ein Werkzeug zum Schneiden einer Kupferplatte entsprechend dem vorgegebenen Lay-out einer elektrischen Schatlungsplatte zu schaffen, das flexibel ist und bei dem die schneidenden Werkzeuge selbst nicht speziell auf das Schaltungsmuster zugeschnitten hergestellt werden müssen.

Die gestellte Aufgabe ist erfindungsgemäß durch die Merkmale des Anspruchs 1 gelöst.

Bei einem derartigen Werkzeug werden weder Stempel noch Niederhalter bei der Umstellung auf ein anderes Schaltungsmuster ausgewechselt. Es brauchen deshalb also keine Spezialmatrizen und Niederhalter hergestellt zu werden. Das jeweilige geschnittene Muster wird von den Programmplatten vorgegeben, die mit großen Toleranzen behaftet ausgeführt sein können, da die Programmplatten keine selbstschneidenden Kanten haben, vielmehr nur Druck auf die einzelnen Stempel und Niederhalter ausüben.

Es ist an sich bekannt (DE-OS 31 09 862), Lochstempel in den Kreuzen éines Matrixmusters gegeneinander auszutauschen, um so die Lochsstempel zu versetzen für andere Lochungsmuster.

Nach einer weiteren Ausgestaltung der Erfindung ist vorgesehen, daß die Höhe bzw. Tiefe der Schaltungsmuster in den Programmplatten überwiegend etwa der halben Dicke der Kupferplatte entsprechen. Bei einer derartigen Bemessungen der Höhen und Tiefen wird sichergestellt, daß zwischen den einzelnen Leitungs- und Massezügen sowie Anschlußstellen für Bauteile nach vollzogenem Schneiden noch ein ausreichend fester Zusammenhalt besteht, so daß eine so geschnittene Kupferplatte dann sicher in eine Spritzform eingebracht werden kann.

Nach einer weiteren Ausgestaltung der Erfindung ist vorgesehen, daß die Stempel- und Niederhalterflächen quadratisch ausgebildet sind. Eine solche quadratische Ausbildung gibt mehr Freiheit für die Gestaltung des Schaltungsmusters.

Nach einer weiteren Ausgestaltung der Erfindung ist vorgesehen, daß mehrere derartige Einzelwerkzeuge zu einem Gesamtwerkzeug zusammengefaßt sind. Hierdurch läßt sich die Außenabmessung der jeweiligen herzustellenden Schaltungsplatte den Anforderungen entsprechend gestalten.

Ein Schaltungsmuster für das Werkzeug muß sich nach den Gestaltungsmöglichkeiten des Werkzeuges richten. Dementsprechend ist nach einer weiteren Ausgestaltung der Erfindung vorgesehen, daß alle Leiterformen des Musters und alle Zwischenbereiche zwischen ihnen im Matrixmuster aus Teilflächen, die den Stempel- und Niederhalterflächen entsprechen, zusammengesetzt sind. In weiterer Ausgestaltung der Erfindung ist dabei vorgesehen, daß die Anschlußpunkte für Bauelemente aus mehreren, zu einer Gruppe zusammengefaßten Stempel- und Niederhalterflächen und die Leitungs- und Massezüge aus aneinandergereihten Stempel- und Niederhalterflächen aufgebaut sind. Ein derartiger Aufbau ist ohne weiteres möglich und darüber hinaus auch sinnvoll.

Die Erfindung wird anhand des in der Zeichnung dargestellten Ausführungsbeispieles näher erläutert. Es zeigen:

Fig. 1 Stempel- und Niederhalter-Einheiten eines Schneidwerkzeuges, bestehend aus vielen im Matrixraster angeordneten Einzelstempeln bzw. Einzel-Niederhaltern, zum Schneiden von Kupferplatten entsprechend vorgegebenen elektrischen Schaltungszugmustern,

Fig. 2 eine Programmplatte für das Werkzeug in Ansicht von der Schaltungsmusterseite her,

Fig. 2a die Verteilung verschiedener Programmebenen auf der Schaltungsmusterseite nach Fig. 2,

Fig. 3 eine Programmplatte für die Niederhalterseite des Werkzeuges von der Schaltungsmusterseite her,

Fig. 3a die Verteilung verschiedener Programmebenen auf der Schaltungsmusterseite nach Fig. 3,

Fig. 4 das Werkzeug mit Stempeln, Niederhaltern, zwei Programmplatten und einer Kupferplatte als Werkstück vor dem Schneidvorgang im auseinandergerückten Zustand,

Fig. 5 das Werkzeug nach Fig. 4 nach dem Schneiden der Kupferplatte im zusammengefahrenen Zustand,

Fig. 6 ein Schaltungsmuster, das mit Hilfe des Werkzeuges nach den Fig. 1 bis 5 aus einer Kupferplatte schneidbar ist.

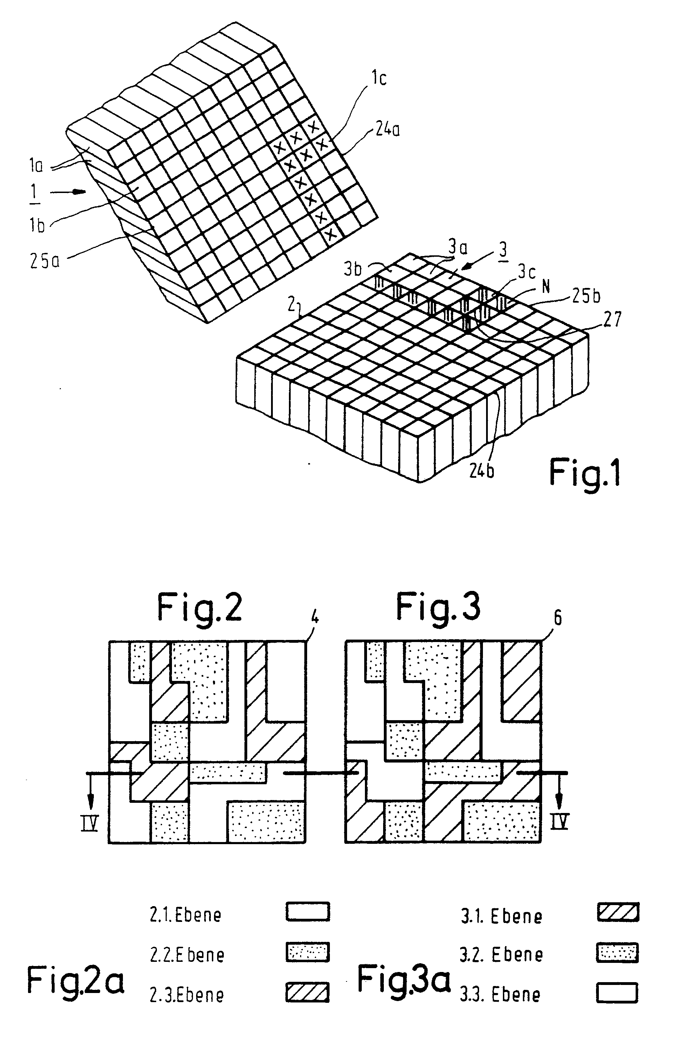

In Fig. 1 sind ein Stempel 1 und ein Niederhalter 3 eines Werkzeuges zum Schneiden eines Schaltungsmustes einer elektrischen Schaltungsplatte dargestellt. Der Stempel 1 und der Niederhalter 3 bestehen aus einer Vielzahl von Einzelstempeln 1a und Einzel-Niederhaltern 3a mit gleichen quadratischen Stempelflächen 1b bzw. Niederhalterflächen 3b. Die Stempelflächen 1b und die Niederhalterflächen 3b der Einzelstempel 1a und Einzel-Niederhalter 3b liegen in einem Matrixraster nebeneinander, wobei jeder Einzelstempel 1a mit einem Einzel-Niederhalter 3a fluchtet. Die in Fig. 1 schaubildlich dargestellten Stempel 1 und Niederhalter 3 werden geführt in einem Werkzeugrahmen, der der Einfachheit und Übersichtlichkeit wegen nicht dargestellt ist.

Die Stempel 1 und die Niederhalter 3 werden betätigt von Programmplatten 4 und 6, die in Fig. 2 und 3 von ihrer programmgebenden Seite 5, 7 her dargestellt sind. Auf der programmgebenden Seite sind die Programmplatten 4, 6 reliefartig mit drei Programmebenen versehen, die sich aus dem in Fig. 2 dargestellten Schaltungsmuster ergeben. Die Ebene 2.1 ist dabei weiß gehalten, die Ebene 2.2 gepunktet und die Ebene 2.3 schräg schraffiert (Fig. 2a). Entsprechendes gilt für die Programmplatte 3, in der, diesmal umgekehrt, die Ebene 3.1 schräg schraffiert, die Ebene 3.2 gepunktet und die Ebene 3.3 weiß ausgeführt sind. Dementsprechend ergibt sich auf der Programmseite 5 der Programmplatte 4 ebenso wie auf der Programmseite 7 der Programmplatte 6 ein Schaltungsmusterrelief. Dieses Schaltungsmusterrelief ist in der Programmplatte 4 für die Stempel 1 überwiegend positiv hervorstehend und in der Programmplatte 6 für die Niederhalter 3 überwiegend negativ eingelassen ausgebildet; beide Programmseiten sind spiegelbildlich zueinander. Die Ränder 10 des Schaltungsmusters bzw. des Reliefs sind vorzugsweise etwas zurückgenommen oder angefast, damit die gegenseitige Bewegung der Einzelstempel oder Einzel-Niederhalter nicht beeinträchtigt wird. Es kommt bei der Ausbildung der Programmseiten nur darauf an, daß die Einzelstempel bzw. Einzel-Niederhalter sicher beaufschlagt werden.

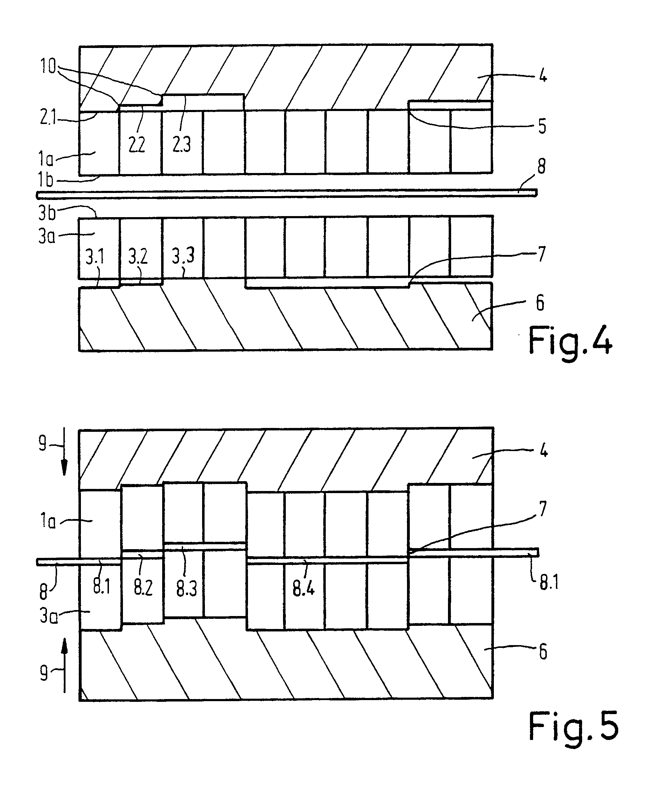

Die Fig. 4 und 5 zeigen die Programmplatten 4 und 6 im Schnitt längs der Linie IV-IV nach Fig. 2 und 3, wobei jeweils die drei Programmebenen 2.1 bis 2.3 und 3.1 bis 3.3 erkennbar sind.

Anhand der Fig. 4 und 5 wird nun die Wirkungsweise des Werkzeuges dargestellt. In einem nicht dargestellten Werkzeughalter befinden sich auf gleichmäßiger Höhe alle Stempel 1a, wobei die Stempelflächen 1b einer (vernickelten) Kupferplatte 8 zugewandt sind. Auf der von den Stempelflächen 1b abliegenden Seite der Stempel 1a ist die Programmplatte 4 nach Fig. 2 mit ihrer Programmseite 5 angeordnet. Diese Programmplatte 4 ist gegen die Stempel 1 fahrbar. Die Niederhalter 3a liegen mit ihren Schneidflächen 3b der (vernickelten) Kupferplatte 8 auf der anderen Seite gegenüber. Auch die Niederhalter 3a sind in einem nicht dargestellten Werkzeughalter geführt. Auf der von den Niederhalterflächen 3b abliegenden Seiten der Niederhalter befindet sich die Programmplatte 6 nach Fig. 3 mit ihrer Programmseite 7.

Nach dieser Arbeitsvorbereitung durch das Zwischenschieben der Kupferplatte 8 und das Auflegen der Programmplatten 4 und 6 sind die vorbereiteten Arbeitsvorgänge vor dem Schneiden der Kupferplatte 8 abgeschlossen. Wie Fig. 5 zeigt, werden dann die Programmplatten 4 und 6 in Richtung der Pfeile 9 gegeneinander gefahren, wobei sich die Stempel 1 und die Niederhalter 3 aufgrund der spiegelbildlichen Ausbildung der Programmflächen 5 und 7 verschieben. Die Kupferplatte 8 wird dabei zerschnitten in Plattenteile 8.1, 8.2, 8.3 und 8.4. Sind die Höhenverhältnisse des Schaltungsmusterreliefs so gehalten, daß sie die halbe Dicke der Kupferplatte an den meisten Stellen nicht überschreiten, dann bleibt die Kupferplatte auch nach dem tchneiden noch als, wenn auch in der Struktur aufgelöste Platte bestehen. Das Abstreifen nach dem Schneiden erfolgt durch eine ebene "Programmplatte" auf beiden Seiten.

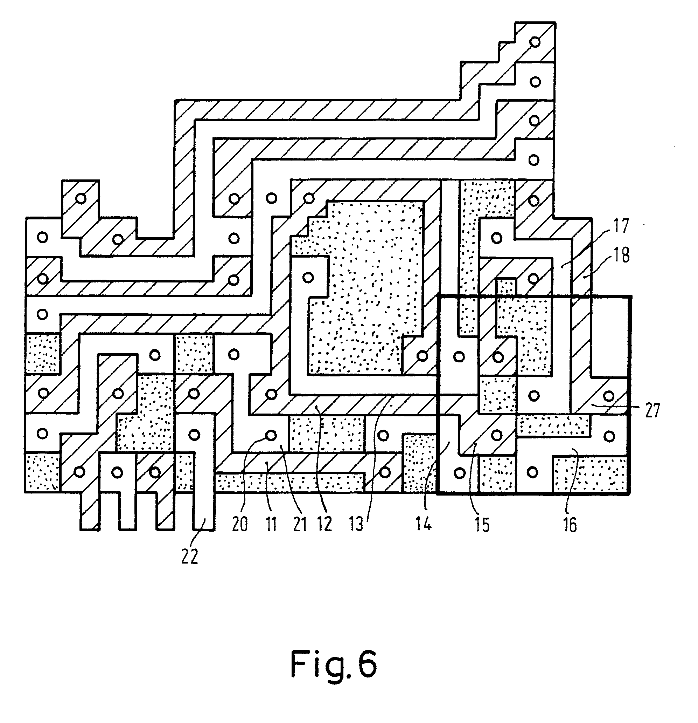

Fig. 6 zeigt ein Schaltungsmuster, welches speziell für das Werkzeug mit dem Matrixraster der Stempel und Niederhalter geeignet ist. Das Schaltungsmuster nach Fig. 6 besteht aus nur beispielhaft angezogenen Leiterbahnen 11, 12, 13, 14, 15, 16, 17, 18 usw.. Die Leitungszüge sind jeweils an ihren mit Durchbrüchen 20 versehenen Enden zu Lötanschlußstellen 21 erweitert. In der Darstellung nach Fig. 6 liegen einige Leiterbahnen Kante auf Kante aneinander an. Dies ist deswegen möglich, weil nach dem Schneiden der Kupferplatte 8 diese aufgelöste Kupferplatte in eine Spritzform eingebracht wird. Im Hohlraum der nicht dargestellten Spritzform werden die Leitungszüge mittels nicht dargestellter Stifte des Werkzeuges in unterschiedliche Ebenen gedrückt. Diese unterschiedlichen Ebenen liegen weiter auseinander als die Ebenen 2.1 bis 2.3 oder 3.1 bis 3.3 des Schaltungsmusterreliefs auf den Programmseiten 5 und 7 der Programmplatten 4 und 6. Die später in die verschiedenen Ebenen gedrückten Leitungszüge, die auch masseführend sein können, werden vollständig beim Spritzen in Kunststoff eingebettet. Frei bleiben nur die Anschlußstellen für Bauelemente und beispielsweise Anschlußnasen 22, die zur Kontaktierung herausführbar sind.

Nicht alle Züge des Schaltungsmusters werden zur Stromführung benötigt. Die nicht benötigten Leitungszüge können der Wärmeableitung und Versteifung dienen.

Das Prinzip des Schaltungsmusters nach Fig. 6 ist darin zu sehen, daß die einzelnen Leitungszüge gebildet sind aus aneinander gereihten einzelnen Stempel- oder Niederhalterflächen. Als Beispiel sei der Leitungszug 18 herausgegriffen. Dieser wird aus Teilflächen 3c der Niederhalter 3a gebildet, die in Fig. 1 schräg gestrichelt sind. Bei den Stempeln sind die entsprechenden Stempelflächen 1c mit Sternchen angedeutet, wobei Voraussetzung ist, daß die Kanten 24a und 24b parallel zueinander geführt werden, ebenso wie die Kanten 25a und 25b. Anhand des Leitungszuges 18 in Fig. 6 in Verbindung mit Fig. 1 ist zu erkennen, daß der Leitungszug selbst aus einer Aneinanderreihung von quadratischen Stempel- oder Niederhalterflächen 1b und 3b gebildet ist. Die Anschlußstelle 27 wird aus zu einer Gruppe zusammengefaßten quadratischen Stempel- oder Niederhalterflächen gebildet.

In Fig. 6 ist der Teil des Schaltungsmusters, der sich in dem Werkzeug nach den Fig. 1 bis 5 wiederfindet, dick strichpunktiert umrandet. Um zu der Gesamtschaltungsplatte zu kommen, werden mehrere solche Werkzeuge nebeneinander zum Einsatz gebracht.

**Patentansprüche**

1. Werkzeug zum Herstellen eines Schaltungsmusters einer elektrischen Schaltungsplatte mit Leitungs- und Massezügen sowie Anschlußstellen für Bauteile nach einem vorgegebenen Lay-out durch Schneiden einer Kupferplatte mit Hilfe von Werkzeugstempeln und den Stempeln zugeordneten Niederhaltern längs der Ränder der Züge und Anschlußstellen, mit folgenden Merkmalen :
   - die beiderseits der Kupferplatte (8) angeordneten Werkzeugteile sind vollständig aus Einzelstempeln (1a) und verschieblichen Einzel-Niederhaltern (3a) mit aneinander anschließenden Stempel- und Niederhalterflächen (1b, 3b) einheitlich rechteckigen Querschnittes versehen und nach Art eines Matrixrasters nebeneinander angeordnet,
   - Es sind Programmplatten (4, 6) an den von der Kupferplatte (8) wegliegenden Stempel- und Niederhalterenden vorgesehen,
   - die Programmplatte (4, 6) weist zu den Stempeln (1) bzw. Niederhaltern (3) spiegelbildlich ausgebildete Schaltungsmusterreliefs (5, 7) auf, so daß beim Gegeneinanderdrücken der Programmplatten (4, 6) zwischen den sich verschiebenden Stempeln (1) und Niederhaltrn (3) die Kupferplatte (8) dem Relief (5, 7) entsprechend geschnitten wird.

2. Werkzeug nach Anspruch 1, dadurch gekennzeichnet, daß die Höhe bzw. Tiefe der Schaltungsmuster in den Programmplatten (4, 6) etwa der halben Dicke der Kupferplatte (8) entsprechen.

3. Werkzeug nach Anspruch 1, dadurch gekennzeichnet, daß die Stempel- (1b) und Niederhalterflächen (3b) quadratisch ausgebildet sind.

4. Werkzeug nach den Ansprüchen 1 bis 3, dadurch gekennzeichnet, daß mehrere derartige Einzelwerkzeuge zu einem Gesamtwerkzeug zusammengefaßt sind.

5. Schaltungsmuster für ein Werkzeug nach einem oder mehreren der Ansprüche 1 bis 4, dadurch gekennzeichnet, daß alle Leiterformen (11 bis 18) des Musters und alle Zwischenbereiche zwischen ihnen im Matrixraster aus Teilflächen, die den Stempel- (1b) und Niederhalterflächen (3b) entsprechen, zusammengesetzt sind.

6. Schaltungsmuster nach Anspruch 5, dadurch gekennzeichnet, daß die Anschlußpunkte (21) für Bauelemente aus mehreren, zu einer Gruppe zusammengefaßten Stempel- und Niederhalterflächen aufgebaut sind.

7. Schaltungsmuster nach Anspruch 5, dadurch gekennzeichnet, daß die Leitungs- und Massezüge (11 bis 18) aus aneinandergereihten Stempel- (1b) und Niederhalterflächen (3b) aufgebaut sind.

**Claims**

1. A tool for manufacturing a circuit pattern of an electrical circuit board having conductor and mass tracks as well as connection areas for components according to a given layout through cutting of a copper plate by means of punches and dies associated with the punches along the edges of the tracks and connection areas, with the following characteristics:
   - the tool parts positioned on either side of the copper plate (8) entirely consist of individual punches (1a) and adjustable individual dies (3a) provided with consecutively arranged punch and die surfaces (1b, 3b) of uniformly rectangular cross-section and are arranged next to one another in a matrix raster,
   - program plates (4, 6) are arranged at the punch and die ends facing away from the copper plate (8),
   - the program plates (4, 6) have circuit pattern reliefs (5, 7) arranged as mirrored images relative to the punches (1) and dies (3), respectively, so that, when the program plates (4, 6) are pressed against each other, the copper plate (8) is cut between the moving punches (1) and the dies (3) in accordance with the relief (5, 7).

2. A tool as claimed in Claim 1, characterized in that the respective heights and depths of the circuit patterns in the program plates (4, 6) substantially correspond to half the thickness of the copper plate (8).

3. A tool as claimed in Claim 1, characterized in that the surfaces of punches (1b) and dies (3b) are of square shape.

4. A tool as claimed in Claims 1 to 3, characterized in that several of such individual tools are combined into an integrated tool.

5. A circuit pattern for a tool as claimed in any one of Claims 1 to 4, characterized in that all the conductor shapes (11 to 18) of the pattern and all the intermediate areas between them in the matrix pattern are composed of subsurfaces corresponding to the surfaces of the punches (1b) and dies (3b).

6. A circuit pattern as claimed in Claim 5, characterized in that the connection points (21) for components are composed of several surfaces of punches and dies combined into a group.

7. A circuit pattern as claimed in Claim 5, characterized in that the conductor and mass tracks (11 to 18) are composed of consecutively arranged punch (1b) and die (3b) surfaces.

**Revendications**

1. Outil de fabrication d'un motif de circuit d'une plaque de circuit imprimé, munie de pistes conductrices et de masse ainsi que de points de raccordement pour des composants, suivant une conception préétablie par découpage d'une plaque en cuivre le long des bords des pistes et des points de raccordement à l'aide de poinçons et de serre-plaque associés aux poinçons, outil ayant les caractéristiques suivantes:
   - les parties d'outil disposées des deux côtés de la plaque en cuivre (8) sont constituées entièrement de poinçons individuels (1a) et de presse-plaque individuels (3a) mobiles présentant des surfaces de poinçon et de presse-plaque (1b, 3b) jointives de section transversale uniformément rectangulaire, et sont disposées les unes à côté des autres suivant un motif matriciel,
   - des plaques à programme (4, 6) sont prévues aux extrémités des poinçons et des presse-plaque situées à l'opposé de la plaque en cuivre (8),
   - la plaque à programme (4, 6) présente des reliefs de motif de circuit (5, 7) realisés en image inverse des poinçons (1) ou des presse-plaque (3), de sorte que, si les plaques à programme (4, 6) sont pressées l'une contre l'autre, la plaque en cuivre (8) est découpée, en mouvement, entre les poinçons (1) et les presse-plaque (3) suivant le relief (5, 7).

2. Outil selon la revendication 1, caractérisé en ce que la hauteur ou la profondeur du motif de circuit dans les plaques à programme (4, 6) correspondent à peu près à la moitié de l'épaisseur de la plaque en cuivre (8).

3. Outil selon la revendication 1, caractérisé en ce que les surfaces de poinçon (1b) et de presse-plaque (3b) présentent une forme carrée.

4. Outil selon les revendications 1 à 3, caractérisé en ce que plusieurs de tels outils individuels sont réunis en un outil combiné.

5. Motif de circuit pour un outil selon une ou plusieurs des revendications 1 à 4, caractérisée en ce que toutes les formes de pistes conductrices (11 à 18) du motif et toutes les zones intermédiaires qui les séparent dans le motif matriciel sont constituées de surfaces partielles qui correspondent aux surfaces de poinçon (1b) et de presse-plaque (3b).

6. Motif de circuit selon la revendication 5, caractérisée en ce que les points de raccordement (21) destinés aux composants sont constitués de plusieurs surfaces de poinçon et de presse-plaque réunies en un groupe.

7. Motif de circuit selon la revendication 5, caractérisée en ce que les pistes conductrices et de masse (11 à 18) sont constituées de surfaces de poinçon et de presse-plaque mises à la file.

1c
24a
1a
1
1b
25a

3a
3
3b
3c
N
25b
2
27
24b

Fig.1

Fig.2
4

Fig.3
6

IV
IV

2.1. Ebene
2.2. Ebene
2.3. Ebene

3.1. Ebene
3.2. Ebene
3.3. Ebene

Fig.2a
Fig.3a

Fig.4

Fig.5

Fig.6